# EUROPÄISCHE PATENTSCHRIFT

(11) **EP 1 709 681 B1**
(45) Veröffentlichungstag und Bekanntmachung des Hinweises auf die Patenterteilung: **30.03.2011**
(21) Anmeldenummer: 04805058.7
(22) Anmeldetag: 30.12.2004
(51) Int. Cl.: H01L 21/8242

(54) **HALBLEITERSPEICHERZELLE SOWIE ZUGEHÖRIGES HERSTELLUNGSVERFAHREN**
SEMICONDUCTOR MEMORY CELL AND CORRESPONDING METHOD OF PRODUCING THE SAME
CELLULE MÉMOIRE A SEMI-CONDUCTEUR ET PROCÉDÉ DE RÉALISATION CORRESPONDANT

(30) Priorität: 29.01.2004 DE 102004004584
(43) Veröffentlichungstag der Anmeldung: 11.10.2006
(73) Patentinhaber: Infineon Technologies AG, 85579 Neubiberg (DE)
(72) Erfinder: NIRSCHL, Thomas, 84180 Loiching (DE); OLBRICH, Alexander, D-85640 Putzbrunn (DE); OSTERMAYR, Martin, 85622 Feldkirchen (DE)
(74) Vertreter: Kindermann, Peter
(86) Internationale Anmeldenummer: PCT/EP2004/053733
(87) Internationale Veröffentlichungsnummer: WO 2005/074024

(56) Entgegenhaltungen:
- DE-A1- 19 757 490
- DE-A1- 19 822 797
- US-A- 5 172 201
- US-A- 5 627 094
- US-A- 5 644 151
- US-B1- 6 335 552
- PATENT ABSTRACTS OF JAPAN Bd. 011, Nr. 288 (E-542), 17. September 1987 (1987-09-17) & JP 62 086853 A (FUJITSU LTD), 21. April 1987 (1987-04-21)

## Beschreibung

Die vorliegende Erfindung bezieht sich auf eine Halbleiterspeicherzelle sowie ein zugehöriges Herstellungsverfahren und insbesondere auf eine Halbleiterspeicherzelle mit Kontaktloch-Kondensator.

Zukünftige Halbleiterbausteine weisen einen hohen Bedarf für große und hochdichte Speicherbereiche auf. Der Gesamtverbrauch an zur Verfügung stehender Chipfläche für derartige eingebettete Speicherbereiche (embedded memory) weist bereits heute ca. 50 % der gesamten Chipfläche auf und wird weiter steigen. Es werden daher hochdichte Halbleiterspeicherzellen benötigt, um den Speicherbereich so klein wie möglich zu halten und eine Gesamtgröße des Halbleiterbausteins zu verringern, wodurch sich auch die Herstellungskosten reduzieren lassen. Aus diesem Grund zeigt sich in der Halbleiterindustrie eine Trendwende weg von herkömmlichen 6-Transistor-Halbleiterspeicherzellen hin zu 1-Transistor-, 2-transistor-und 3-Transistor-Halbleiterspeicherzellen (1T, 2T, 3T), wodurch man eine höhere Integrationsdichte, eine verbesserte Ausbeute und eine geringere Empfindlichkeit gegenüber sogenannten soft errors (soft error sensitivity) bei verringerten Leckströmen erhält.

Im Gegensatz zu einer 6-Transistor-Halbleiterspeicherzelle benötigen jedoch 1-Transistor-, 2-Transistor- und 3-Transistor-Halbleiterspeicherzellen eine Kapazität bzw. einen Kondensator zum Speichern von Ladungen sowie ein Auffrischen der gespeicherten Ladungen in vorbestimmten Zeitabständen (refresh). Da die Auffrisch-Rate von eingebetteten 1T-, 2T-und 3T-Halbleiterspeicherzellen wesentlich höher sein kann als die von herkömmlichen TRAMS (Dynamic Random Access Memories) können kleine Speicherkondensatoren verwendet werden.

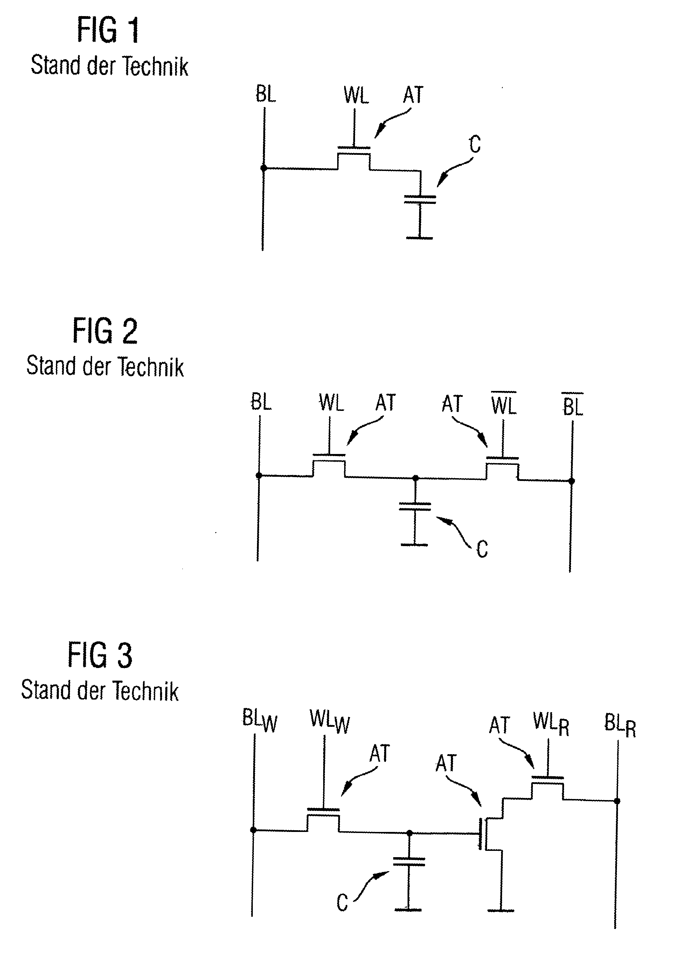

Die Figuren 1 bis 3 zeigen vereinfachte Ersatzschaltbilder für eine jeweilige 1-Transistor-, 2-Transistor- und 3-Transistor-Halbleiterespeicherzelle, wobei mit BL eine Bitleitung, mit WL eine Wortleitung und mit AT ein jeweiliger Auswahltransistor bezeichnet werden, über die ein Speicherkondensator C angesteuert werden kann.

Gemäß Figur 2 sind in der 2-Transistor-Halbleiterspeicherzelle darüber hinaus invertierte Wortleitungen WL/ und invertierte Bitleitungen BL/ vorhanden, die über einen weiteren Auswahltransistor AT den Speicherkondensator C ansteuern.

Gemäß Figur 3 wird in der 3-Transistor-Halbleiterspeicherzelle der Speicherkondensator C einerseits über eine Schreib-Bitleitung BL_{W} und eine Schreib-Wortleitung WL_{W} sowie einen zugehörigen Auswahltransistor AT beschrieben und über eine Lese-Wortleitung WL_{R} und eine Lese-Bitleitung BL_{R} und zugehörige zwei weitere Auswahltransistoren AT ausgelesen.

Zur Realisierung derartiger 1T-, 2T-, 3T-Halbleiterspeicherzellen werden beispielsweise sogenannte eingebettete DRAM-Halbleiterspeicherzellen verwendet.

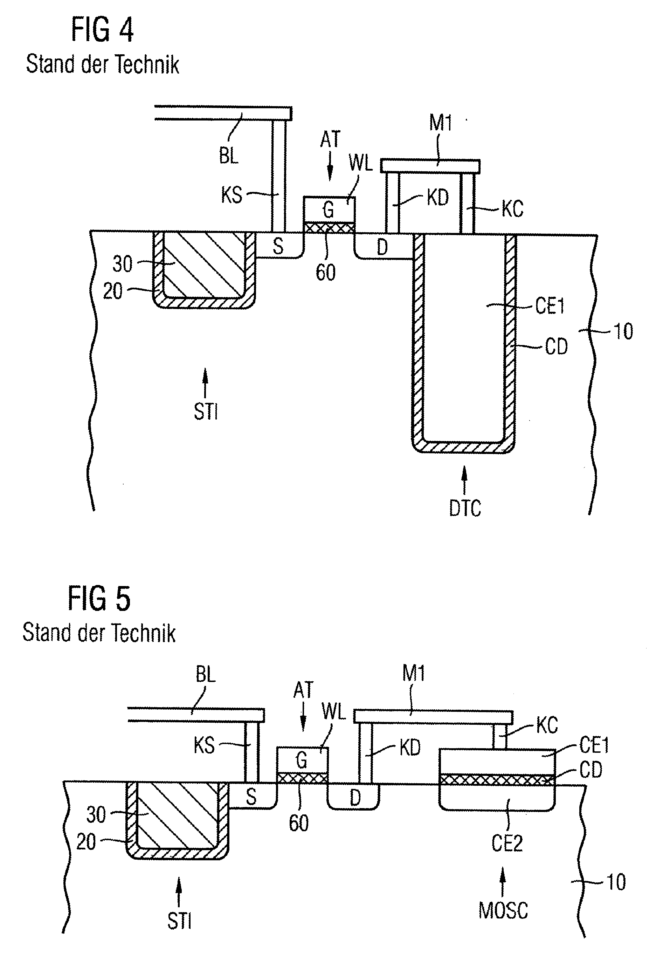

Figur 4 zeigt eine vereinfachte Schnittansicht einer derartigen 1-Transistor-Halbleiterspeicherzelle mit tiefem Grabenkondensator.

Gemäß Figur 4 befindet sich hierbei in einem Halbleitersubstrat 10 ein tiefer Graben zur Realisierung eines tiefen Grabenkondensators DTC (Deep Trench Capacitor), wobei an der Grabenoberfläche ein Kondensatordielektrikum (CD) und an der Oberfläche des Kondensatordielektrikums eine elektrisch leitende Füllschicht als erste Kondensator-Elektrode CE1 ausgebildet ist, die gemeinsam mit dem Halbleitersubstrat 10 als weiterer Kondensator-Elektrode den tiefen Grabenkondensator DTC realisiert. Als Auswahltransistor AT werden üblicherweise Feldeffekttransistoren mit einem Sourcegebiet S und einem Draingebiet D zum Festlegen eines Kanals im Halbleitersubstrat 10 verwendet, wobei an der Oberfläche des Kanals ein Gate-Dielektrikum 60 und darauf eine Steuerelektrode bzw. ein Gate G ausgebildet ist, welche im Wesentlichen eine Wortleitung WL realisiert. Das Sourcegebiet S ist beispielsweise über einen Sourcekontakt KS bzw. ein entsprechendes Kontaktvia mit einer Bitleitung BL verbunden, die sich beispielsweise in einer Metallisierungsebene befindet. In ähnlicher Weise ist das Draingebiet D beispielsweise über eine erste Metallisierungsebene M1, einen Drainkontakt KD und einen Kondensatorkontakt KC mit dem tiefen Grabenkondensator DTC bzw. dessen erste Kondensator-Elektrode CE1 verbunden.

Ferner weisen Halbleiterschaltungen zum Festlegen von aktiven Gebieten AA und insbesondere zum Isolieren der Schaltelemente wie beispielsweise des Auswahltransistors AT sogenannte flache Grabenisolierungen STI (Shallow Trench Isolation) auf, die beispielsweise eine isolierende Linerschicht 20 und eine Isolations-Füllschicht 30 aufweisen.

Obwohl mit derartigen DRAM-Halbleiterspeicherzellen aufgrund der Verwendung von tiefen Grabenkondensatoren DTC Halbleiterspeicherzellen mit sehr geringem Platzbedarf realisiert werden können, sind die Kosten insbesondere aufgrund des Herstellungsprozesses für den tiefen Grabenkondensator DTC außerordentlich hoch.

Üblicherweise werden daher 1T-, 2T- und 3T-Halbleiterspeicherzellen derzeit mit sogenannten MOS/MIM-Kondensatoren (MOS/MIM-Caps) realisiert, die in ihrer Herstellung wesentlich kostengünstiger sind.

Figur 5 zeigt eine vereinfachte Schnittansicht einer 1-Transistor-Halbleiterspeicherzelle mit einem derartigen MOS-Kondensator MOSC, wobei gleiche Bezugszeichen gleiche oder entsprechende Elemente bezeichnen wie in Figur 4 und auf eine wiederholte Beschreibung nachfolgend verzichtet wird.

Gemäß Figur 5 ist demzufolge der Speicherkondensator durch einen MOS-Kondensator MOSC realisiert, wobei als Kondensator-Gegenelektrode CE2 das Halbleitersubstrat 10 oder ein darin ausgebildetes Dotiergebiet dient, an dessen Oberfläche ein Kondensator-Dielektrikum CD und darauf eine Kondensator-Elektrode bzw. Speicherelektrode CE1 beispielsweise als polykristalline Halbleiterschicht ausgebildet wird. Wiederum wird die Speicherelektrode CE1 über einen Kondensatorkontakt KC sowie einen Drainkontakt KD und eine vorzugsweise erste Metallisierungsebene M1 mit dem Draingebiet D des Auswahltransistors AT elektrisch verbunden. Obwohl auf diese Weise die Kosten wesentlich reduziert werden können, erhöht sich der Flächenbedarf für eine derartige Halbleiterspeicherzelle stark, da der MOS- bzw. MIM-Kondensator MOSC im Wesentlichen an der Oberfläche des Halbleitersubstrats 10 ausgebildet wird und seine Kapazität somit direkt proportional zum Flächenverbrauch der zur Verfügung stehenden Bausteinfläche steht.

Aus den Druckschriften US 5 644 151 A und JP 62 086853 A ist eine Halbleiterspeicherzelle sowie ein zugehöriges Herstellungsverfahren bekannt, wobei Kontaktloch-Kondensatoren in einem Zwischendielektrikum ausgebildet sind. Die Kondensator-Elektroden sowie das dazwischen liegende Kondensator-Dielektrikum reichen hierbei seitlich über das Kontaktloch hinaus.

In gleicher Weise ragen auch bei der Druckschrift US 5 172 201 A die Kondensator-Elektroden sowie das dazwischen liegende Kondensator-Dielektrikum seitlich über die in einem Zwischendielektrikum ausgebildeten Kontaktlöcher hinaus.

Die Druckschrift DE 197 57 490 A1 offenbart eine Halbleiterspeicherzelle sowie ein zugehöriges Herstellungsverfahren, bei dem der Kontaktloch-Kondensator wiederum über das Kontaktloch hinausragt. Die Stirnseiten der ersten Kondensator-Elektroden werden hierbei durch ein weiteres Zwischendielektrikum isoliert.

Ferner ist aus der Druckschrift US 6 335 552 B1 eine Halbleiterspeicherzelle sowie ein zugehöriges Herstellungsverfahren bekannt, wobei in einem Kontaktloch ein Kondensator ausgebildet ist. Auch wenn die Kondensator-Elektrode hierbei nicht über das Kontaktloch hinausragt, so reicht sie dennoch bis zur Oberfläche des Zwischendielektrikums bzw. des Kontaktlochs, wobei das Kondensator-Dielektrikum wiederum seitlich über das Kontaktloch hinausragt.

Schließlich ist aus der den Oberbegriff des Patentanspruchs 1 bildenden Druckschrift DE 198 22 797 A1 eine Halbleiterspeicherzelle bekannt, die einen Kontaktloch-Kondensator zum Speichern von elektrischen Ladungen in zumindest einem Kontaktloch innerhalb eines Zwischendielektrikums und zumindest einen mit dem Kontaktloch-Kondensator verbundenen Auswahltransistor zum Auswählen der Halbleiterspeicherzelle aufweist, wobei der Auswahltransistor ein Sourcegebiet und ein Draingebiet zum Festlegen eines Kanals in einem Halbleitersubstrat aufweist und an der Oberfläche des Kanals ein Gatedielektrikum und darauf eine Steuerelektrode ausgebildet ist.

Der Erfindung liegt die Aufgabe zugrunde, eine Halbleiterspeicherzelle sowie ein zugehöriges Herstellungsverfahren zu schaffen, welches bei erhöhter Integrationsdichte verringerte Herstellungskosten und eine verbesserte Zuverlässigkeit aufweist.

Erfindungsgemäß wird diese Aufgabe hinsichtlich der Halbleiterspeicherzelle durch die Merkmale des Patentanspruchs 1 und hinsichtlich des Herstellungsverfahrens durch die Maßnahmen des Patentanspruchs 10 gelöst.

Insbesondere durch die Verwendung eines Kontaktloch-Kondensators als Speicherkondensator, wobei an der Kontaktlochoberfläche eine erste Kondensator-Elektrode ausgebildet ist, die in ihrem oberen Bereich jedoch nicht bis zur horizontalen Oberfläche des Zwischendielektrikums reicht, und an der Oberfläche dieser ersten Kondensator-Elektrode und des oberen Bereichs des Kontaktlochs ferner ein Kondensator-Dielektrikum ausgebildet ist, welches bis zur horizontalen Oberfläche des Zwischendielektrikums reicht, können bei verringerten Herstellungskosten z.B. Leckströme reduziert werden.

Vorzugsweise weist das zumindest eine Kontaktloch eine kreisrunde, ovale oder rechteckige Form auf, wodurch auf beliebige zur Verfügung stehende Maskenelemente eines Standardprozesses zurückgegriffen werden kann.

Zum Anschließen des Kontaktloch-Kondensators kann ferner eine Kondensator-Anschlussleitung oberhalb des Zwischendielektrikums ausgebildet werden. Da sich derartige Anschlussleitungen üblicherweise in einer Metallisierungsebene befinden, können die Anschlusswiderstände minimal gehalten werden.

Ferner kann die Kondensator-Anschlussleitung zumindest ein Hilfs-Anschlussleitungsstück aufweisen, das im Wesentlichen senkrecht zur Kondensator-Anschlussleitung auf dem Zwischendielektrikum ausgebildet ist. Auf diese Weise kann eine jeweilige Kapazität für einen Gesamt-Kontakt-Kondensator feingranular und beliebig eingestellt werden.

Insbesondere kann hierbei eine Vielzahl von Kontaktloch-Kondensatoren für ein jeweiliges Source- oder Draingebiet eines Auswahltransistors ausgebildet werden, wobei das zumindest eine Hilfs-Anschlussleitungsstück die Vielzahl von Kontaktloch-Kondensatoren parallel miteinander verbindet. Ein derartiger Kondensator kann auch im Nachhinein beispielsweise mittels Laserstrahlen modifiziert bzw. auf eine gewünschte Kapazität eingestellt werden.

Als Kondensator-Dielektrikum wird vorzugsweise ein Siliziumoxid, Siliziumnitrid und/oder ein sogenanntes High-k-Material mit hoher relativer Dielektrizitätskonstante verwendet, wodurch die gewünschten Kapazitäten weiter erhöht werden können.

Hinsichtlich des Herstellungsverfahrens wird zunächst ein Auswahltransistor mit einem Sourcegebiet und einem Draingebiet sowie einem Gate-Dielektrikum und einer Steuerelektrode ausgebildet und darüber ein Zwischendielektrikum abgeschieden. Im Zwischendielektrikum werden anschließend Kontaktlöcher zum zumindest teilweisen Freilegen des Sourcegebiets und des Draingebiets ausgebildet, wobei in zumindest einem Kontaktloch für den späteren Kontaktloch-Kondensator eine Linerschicht als erste Kondensator-Elektrode ausgebildet wird, die jedoch nicht bis zur horizontalen Oberfläche des Zwischendielektrikums heranreicht. Anschließend wird eine weitere dielektrische Schicht als Kondensator-Dielektrikum an der Oberfläche der ersten Kondensator-Elektrode bis hinauf zur horizontalen Oberfläche des Zwischendielektrikums ausgebildet und darauf eine elektrisch leitende Füllschicht als zweite Kondensator-Elektrode innerhalb des zumindest einen Kontaktlochs für den Kontaktloch-Kondensator ausgebildet. Zum Anschließen der zweiten Kondensator-Elektrode wird abschließend eine Kondensator-Anschlussleitung oberhalb des Zwischendielektrikums und der Füllschicht ausgebildet. Da bei diesem Herstellungsverfahren eine Vielzahl von Verfahrensschritten sowohl für das Ausbilden von herkömmlichen Kontaktlöchern als auch für das Ausbilden des Kontaktloch-Kondensators verwendet werden können, werden die Herstellungskosten stark reduziert und die Zuverlässigkeit erhöht.

Insbesondere durch die gleichzeitige Verwendung der üblicherweise vorhandenen elektrisch leitenden Linerschicht sowohl im Kontaktloch für den Kontaktloch-Kondensator als auch im Kontaktloch für das verbleibende Source- oder Draingebiet können die in herkömmlichen Kontaktloch-Verfahren ohnehin vorhandenen Verfahrensschritte bzw. Schichten in vorteilhafter Weise zum Ausbilden der ersten Kondensator-Elektrode des Kontaktloch-Kondensators verwendet werden.

Ferner können die Kondensator-Anschlussleitung sowie die zugehörigen Hilfs-Anschlussleitungsstücke gleichzeitig mit der elektrisch leitenden Füllschicht zur Realisierung der zweiten Kondensator-Elektrode hergestellt werden, wodurch sich die Herstellungskosten weiterhin reduzieren.

In den weiteren Unteransprüchen sind weitere vorteilhafte Ausgestaltungen der Erfindung gekennzeichnet.

Die Erfindung wird nachstehend an Hand von Ausführungsbeispielen unter Bezugnahme auf die Zeichnung näher beschrieben.

Es zeigen:
- Figuren 1 bis 3: vereinfachte Ersatzschaltbilder einer 1T-, 2T- und 3T- Halbleiterspeicherzelle gemäß dem Stand der Technik;
- Figur 4: eine vereinfachte Schnittansicht einer 1T- Halbleiterspeicherzelle mit tiefem Grabenkondensa- tor gemäß dem Stand der Technik;
- Figur 5: eine vereinfachte Schnittansicht einer 1T- Halbleiterspeicherzelle mit MOS-Kondensator gemäß dem Stand der Technik;
- Figuren 6A bis 6C: vereinfachte Schnittansichten zur Veranschaulichung von wesentlichen Verfahrensschritten bei der Her- stellung einer erfindungsgemäßen 1T-Halbleiterspei- cherzelle gemäß einem ersten Ausführungsbeispiel;
- Figuren 7A bis 7C: vereinfachte Schnittansichten zur Veranschaulichung von wesentlichen Verfahrensschritten bei der Her- stellung einer erfindungsgemäßen 1T-Halbleiterspei- cherzelle gemäß einem zweiten Ausführungsbeispiel;
- Figur 8: eine vereinfachte Schnittansicht zur Veranschauli- chung einer erfindungsgemäßen 1T-Halbleiter- speicherzelle gemäß einem dritten Ausführungsbei- spiel;
- Figur 9: eine vereinfachte Draufsicht von erfindungsgemäßen 1T-Halbleiterspeicherzellen gemäß Figur 8;
- Figur 10: eine vereinfachte Draufsicht zur Veranschaulichung von erfindungsgemäßen 1T-Halbleiterspeicherzellen gemäß einem vierten bis sechsten Ausführungsbei- spiel; und
- Figur 11: eine vereinfachte Darstellung zur Veranschaulichung einer Gesamt-Kapazität in Abhängigkeit von einem verwendeten Kondensator-Dielektrikum und einer An- zahl von parallel geschalteten Kontaktloch-Konden- satoren.

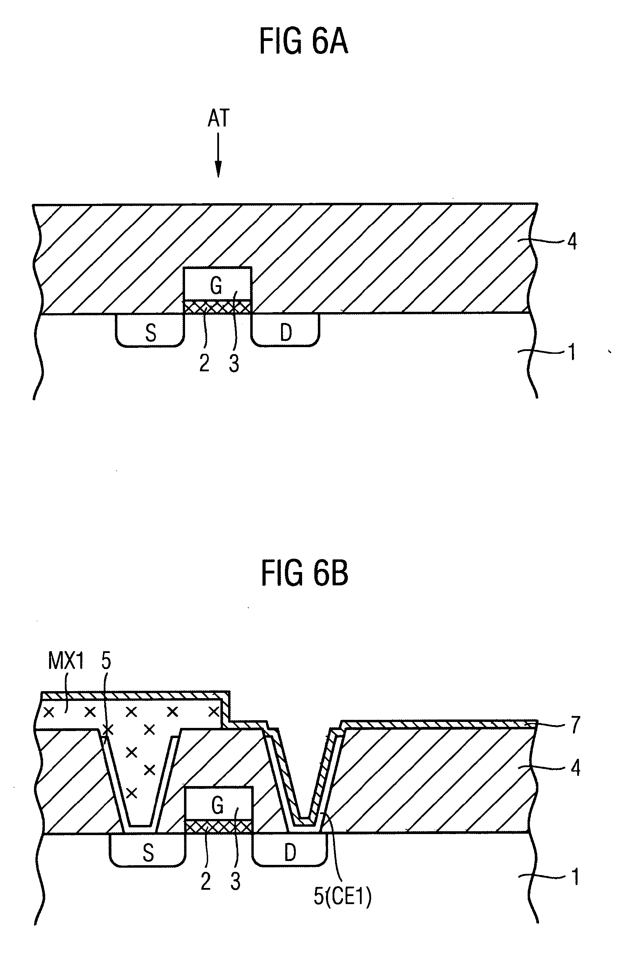

Figuren 6A bis 6C zeigen vereinfachte Schnittansichten zur Veranschaulichung wesentlicher Verfahrensschritte bei der Herstellung einer erfindungsgemäßen 1-Transistor-Halbleiterspeicherzelle gemäß einem ersten Ausführungsbeispiel, wobei gleiche Bezugszeichen gleiche oder entsprechende Elemente bezeichnen wie in den Figuren 1 bis 5 und auf eine wiederholte Beschreibung nachfolgend verzichtet wird.

Gemäß Figur 6A wird zunächst ein Halbleitersubstrat 1 vorbereitet, wobei vorzugsweise ein Si-Halbleitersubstrat verwendet wird. Insbesondere können bei einem derartigen Vorbereitungsschritt nicht dargestellte flache Isolationsgräben STI (Shallow Trench Isolation) zum Festlegen von aktiven Gebieten AA (Active Area) im Halbleitersubstrat 1 ausgebildet werden und/oder entsprechende Wannendotierungen vorgesehen werden.

Anschließend wird ein Auswahltransistor AT zum Auswählen der Halbleiterspeicherzelle im Halbleitersubstrat 1 ausgebildet. Beispielsweise kann hierbei eine Gate-Isolationsschicht 2 zunächst ganzflächig an der Oberfläche des Halbleitersubstrats 1 und darauf eine Steuerelektrodenschicht 3 ganzflächig ausgebildet werden. Mittels beispielsweise fotolithografischer Verfahren werden anschließend sogenannte Gatestapel aus der Gate-Isolationsschicht 2 und der Steuerelektrodenschicht 3 strukturiert, wobei abschließend z.B. mittels Ionenimplantation Source-Gebiete S und Draingebiete D selbst justierend im Halbleitersubstrat 1 an den Seiten des Gatestapels ausgebildet werden. Optional kann hierbei die Steuerelektrodenschicht 3 bzw. die strukturierte Steuerelektrode G zur Erhöhung einer Leitfähigkeit salizidiert werden, wobei unter Verwendung einer abgeschiedenen metallischen Schicht eine hochleitfähige Metall-Halbleiter-Verbindung ausgebildet wird. Die Steuerelektrodenschicht 3 besteht hierfür vorzugsweise aus polykristallinem Halbleitermaterial und insbesondere aus Polysilizium.

Anschließend wird an der Oberfläche des Halbleitersubstrats 1 bzw. des Gatestapels 2 und G ein sogenanntes Zwischendielektrikum ausgebildet, wobei vorzugsweise BPSG (Borphosphorsilikatglas) ganzflächig aufgebracht wird. Die Dicke dieser Schicht bestimmt zum Teil bereits eine Kapazität des späteren Kontaktloch-Kondensators, wobei sie jedoch eine im jeweiligen Verfahren vorgegebene Standarddicke aufweist.

Gemäß Figur 6B erfolgt nunmehr das Ausbilden der Kontaktlöcher im Zwischendielektrikum 4 für das Sourcegebiet S und das Draingebiet D, wobei das Sourcegebiet S und das Draingebiet D zumindest teilweise freigelegt werden bzw. das Halbleitersubstrat 1 an dieser Stelle geöffnet wird. Bei den Kontaktlöchern wird nachfolgend zwischen einem Kontaktloch für den Kontaktloch-Kondensator KK, der im dargestellten Ausführungsbeispiel beispielsweise am Draingebiet D ausgebildet wird, und einem weiteren Kontaktloch, welches an dem verbleibenden Sourcegebiet S ausgebildet wird, unterschieden. Selbstverständlich kann der Kontaktloch-Kondensator auch im Kontaktloch für das Sourcegebiet S und das normale Kontaktloch im Bereich des Draingebiets D ausgebildet werden.

Das Ausbilden dieser Kontaktlöcher erfolgt vorzugsweise gleichzeitig unter Verwendung herkömmlicher Standardprozesse, wobei insbesondere anisotrope Ätzverfahren und vorzugsweise ein sogenanntes RIE-Verfahren (Reactive Ion Etch) verwendet wird. Obwohl die Kontaktlöcher für den Kontaktloch-Kondensator sowie für das verbleibende Sourcegebiet S demzufolge insbesondere gleichzeitig ausgebildet werden, besteht grundsätzlich auch die Möglichkeit, diese Aussparungen bzw. Vertiefungen in voneinander verschiedenen Verfahrensschritten beispielsweise nacheinander durchzuführen.

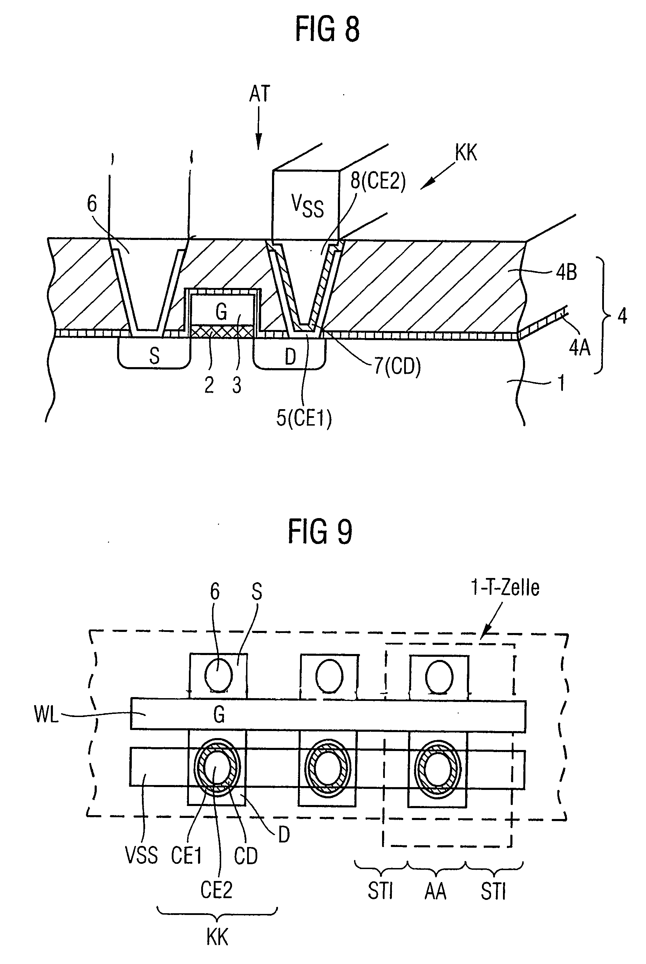

Figur 9 zeigt eine vereinfachte Draufsicht zur Veranschaulichung derartiger 1T-Halbleiterspeicherzellen, wobei gleiche Bezugszeichen gleiche oder entsprechende Elemente bezeichnen wie in den Figuren 1 bis 6 und auf eine wiederholte Beschreibung nachfolgend verzichtet wird.

Gemäß Figur 9 werden vorzugsweise Kontaktlöcher mit unterschiedlicher Größe für den Kontaktloch-Kondensator KK sowie für das verbleibende Sourcegebiet S im Zwischendielektrikum 4 ausgebildet, wodurch man insbesondere eine erhöhte Kondensator-Kapazität für den Kontaktloch-Kondensator als auch einen nahezu gleichen Kontaktwiderstand für das Sourcegebiet S und das Draingebiet D erhält. Insbesondere wird jedoch dadurch das Auffüllen des Kontaktlochs mit einer ersten Kondensator-Elektrode CE1, einem Kondensator-Dielektrikum CD und einer zweiten Kondensator-Elektrode CE2 zur Realisierung des gewünschten Kontaktloch-Kondensators KK stark vereinfacht.

Wieder zurückkehrend zur Figur 6B wird anschließend zumindest im Kontaktloch für den Kontaktloch-Kondensator KK bzw. das Draingebiet D eine elektrisch leitende Linerschicht 5 als erste Kondensator-Elektrode CE1 an seiner Kontaktlochoberfläche, d.h. an der Oberfläche des Zwischendielektrikums 4 sowie an der freigelegten Oberfläche des Halbleitersubstrats 1 im Bereich des Draingebiets D, ausgebildet, wobei aus Isolationsgründen darauf zu achten ist, dass die Linerschicht 5 im oberen Bereich des Kontaktlochs nicht bis zur horizontalen Oberfläche des Zwischendielektrikums 4 heranreicht.

Vorzugsweise wird die Linerschicht 5 gleichzeitig auch im Kontaktloch für das verbleibende Sourcegebiet S an dessen Kontaktlochoberfläche bzw. an der freigelegten Oberfläche des Halbleitersubstrats 1 ausgebildet, da eine derartige Linerschicht üblicherweise standardmäßig in einem Herstellungsverfahren zur Realisierung von Kontakt-Vias bzw. Kontaktelementen vorhanden ist. Demzufolge wird die Linerschicht 5 ganzflächig an einer Wafer-Oberfläche ausgebildet und zur Realisierung einer gewünschten Beabstandung im oberen Bereich des Kontaktlochs zur horizontalen Oberfläche des Zwischendielektrikums 4 eine vorzugsweise anisotrope Rückätzung durchgeführt.

Beispielsweise wird eine ca. 10 nm dicke TiN-Schicht konformal, d.h. mit gleicher Schichtdicke, abgeschieden und mittels eines RIE-Ätzverfahrens zurückgeätzt, wodurch sich im oberen Bereich des Kontaktlochs die dargestellte Rückätzung ergibt.

Dadurch kann auch im unteren bzw. Bodenbereich des Kontaktlochs eine anisotrope Rückätzung der Linerschicht 5 stattfinden, die jedoch nicht schädlich ist, selbst wenn das Halbleitersubstrat 1 bzw. die Source- und Draingebiete S und D freigelegt werden sollten. Mittels dieser elektrisch leitenden Linerschicht 5 wird demzufolge die erste Kondensator-Elektrode CE1 für den Kontaktloch-Kondensator ausgebildet, während sie im herkömmlichen Kontaktloch für das verbleibende Sourcegebiet S im Wesentlichen zur Verbesserung eines Abscheideprozesses und zur Verbesserung einer Leitfähigkeit ausgebildet wird.

Anschließend wird gemäß Figur 6B das Kontaktloch für das verbleibende Sourcegebiet S mit einer ersten Maskenschicht bzw. ersten (unkritischen) Maske MX1 maskiert bzw. aufgefüllt und eine weitere dielektrische Schicht 7 vorzugsweise ganzflächig abgeschieden. Als dielektrische Schicht 7 werden beispielsweise Oxid- und/oder Nitrid-Schichten mit einer Dicke von 3 bis 15 nm und vorzugsweise sogenannte high-k-Dielektrikas mit hoher relativer Dielektrizitätskonstante verwendet.

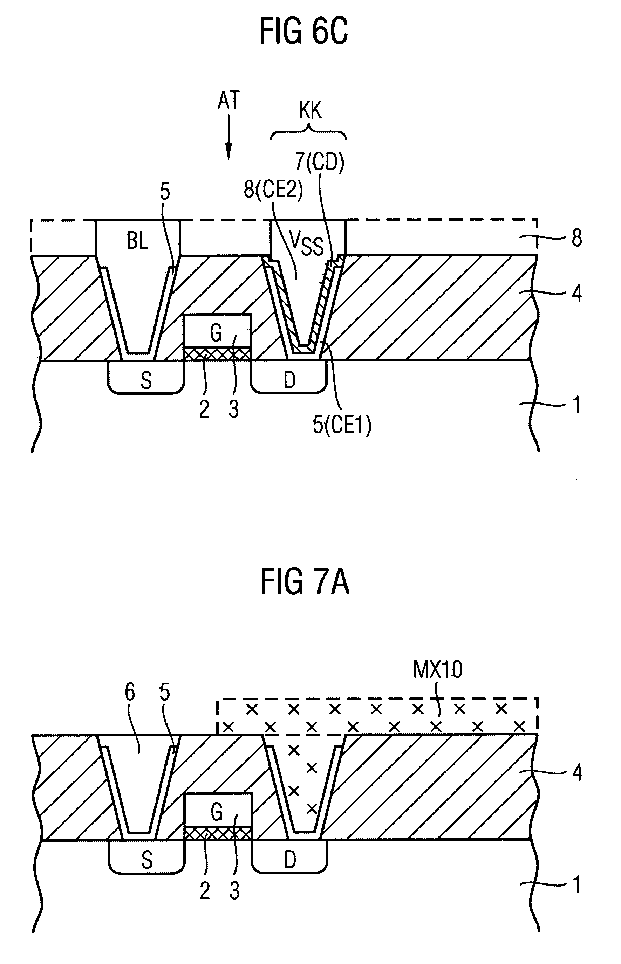

Gemäß Figur 6C wird anschließend beispielsweise eine Planarisierung bis zur Oberfläche des Zwischendielektrikums 4 durchgeführt und die erste Maske MX1 aus dem Kontaktloch für das verbleibende Sourcegebiet S entfernt bzw. gestrippt. Auf diese Weise erhält man im Bereich des Kontaktlochs für den Kontaktloch-Kondensator bzw. das Draingebiet D ein Kondensator-Dielektrikum CD, welches bis zur horizontalen Oberfläche des Zwischendielektrikums 4 reicht und somit auch im oberen Bereich des Kontaktlochs die Linerschicht 5 bzw. die erste Kondensator-Elektrode CE1 zuverlässig isoliert.

Gemäß Figur 6C kann anschließend eine elektrisch leitende Füllschicht 8 an der Oberfläche des Zwischendielektrikums 4 und in den Kontaktlöchern ausgebildet werden, wodurch die Kontaktlöcher vollständig aufgefüllt werden. Vorzugsweise wird hierbei eine bei Kontaktlochverfahren üblicherweise verwendete Wolfram-Schicht als Füllschicht 8 ganzflächig abgeschieden.

Abschließend erfolgt ein fotolithografisches Strukturieren der elektrisch leitenden Füllschicht 8, wodurch eine mit dem Sourcegebiet S in Verbindung stehende Bitleitung BL sowie eine innerhalb des Kontaktlochs ausgebildete zweite Kondensator - Elektrode CE2 mit zugehöriger Kondensator-Anschlussleitung V_{SS} in einem Herstellungsschritt ausgebildet werden kann.

Grundsätzlich kann an Stelle der Strukturierung jedoch auch eine weitere Planarisierung bis zum Zwischendielektrikum 4 durchgeführt werden, wobei die Bitleitung BL und die Kondensator-Anschlussleitung zum Anschließen der zweiten Kondensator-Elektrode CE2 in einem nachfolgenden Metallisierungsschritt in üblicher Weise ausgebildet werden.

Die Figuren 7A bis 7C zeigen weitere vereinfachte Schnittansichten zur Veranschaulichung wesentlicher Verfahrensschritte bei der Herstellung einer erfindungsgemäßen 1-Transistor-Halbleiterspeicherzelle gemäß einem zweiten Ausführungsbeispiel, wobei gleiche Bezugszeichen wiederum gleiche oder entsprechende Elemente bezeichnen wie in den Figuren 1 bis 6 und auf eine wiederholte Beschreibung nachfolgend verzichtet wird.

Die Figur 7A zeigt hierbei eine Schnittansicht, wie sie beispielsweise nach dem vorbereitenden Schritt gemäß Figur 6A alternativ zum ersten Ausführungsbeispiel vorliegen kann.

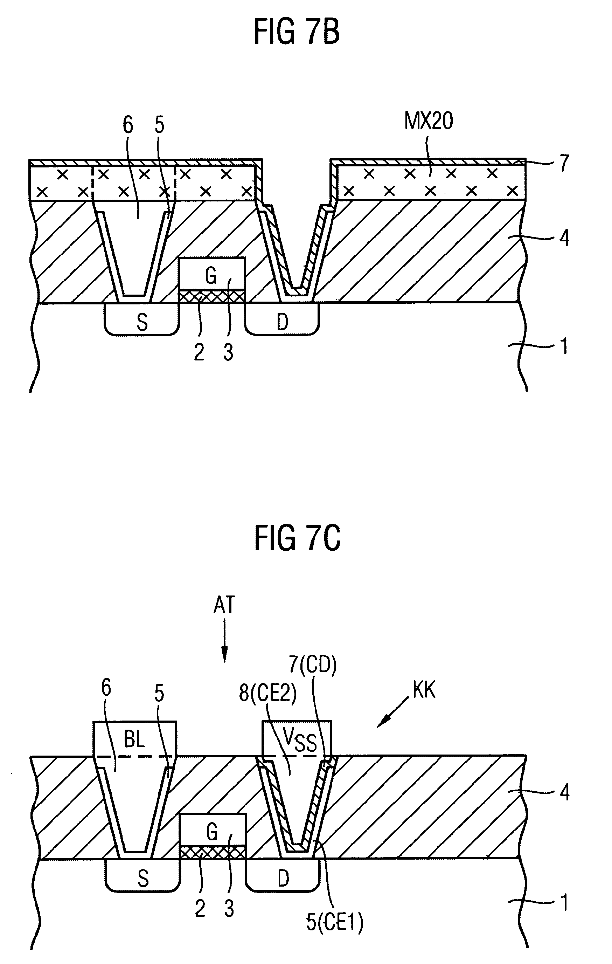

Gemäß diesem zweiten Ausführungsbeispiel werden wie beim ersten Ausführungsbeispiel zunächst die Kontaktlöcher und die Linerschicht 5 ausgebildet. Anschließend wird das Kontaktloch für den späteren Kontaktloch-Kondensator mit einer ersten (unkritischen) Maske MX10 abgedeckt bzw. aufgefüllt und anschließend das Kontaktloch für das verbleibende Sourcegebiet S mit einer zweiten elektrisch leitenden Füllschicht 6 (z.B. Wolfram) zum Vervollständigen des Kontaktelements für das Sourcegebiet S aufgefüllt. Beispielsweise kann hierbei die zweite leitende Füllschicht wiederum ganzflächig abgeschieden werden, wobei anschließend eine Planarisierung durchgeführt wird. Nach dem Planarisieren werden auch die im Kontaktloch für den Kontaktloch-Kondensator verbleibenden Teile der ersten Maske MX10 entfernt bzw. gestrippt und eine zweite Maskenschicht MX20 derart an der Oberfläche des Zwischendielektrikums 4 ausgebildet, dass nur ein Bereich des Kontaktlochs für den Kontaktloch-Kondensator bzw. für das Draingebiet D frei bleibt. Anschließend erfolgt wiederum eine ganzflächige Abscheidung der dielektrischen Schicht 7, welche schließlich das Kondensator-Dielektrikum CD ausbildet, sowie einer ersten leitenden Füllschicht 8, z.B. W. Eine derartige Schnittansicht ist in Figur 7B dargestellt.

Gemäß Figur 7C kann anschließend wiederum entweder ein Planarisieren bis zur Oberfläche des Zwischendielektrikums 4 durchgeführt werden, wobei anschließend eine Bitleitung BL und eine Kondensator-Anschlussleitung V_{SS} an der Oberfläche der ersten leitenden Füllschicht 8 bzw. der zweiten Kondensator-Elektrode CE2 sowie der zweiten leitenden Füllschicht 6 ausgebildet wird.

Vorzugsweise wird jedoch die Kondensator-Anschlussleitung V_{SS} einstückig mit der ersten elektrisch leitenden Füllschicht 8 zur Realisierung der zweiten Kondensator-Elektrode CE2 im Kontaktloch für den Kontaktloch-Kondensator ausgebildet, wobei die Bitleitung BL in einem nachfolgenden Verfahrensschritt ausgebildet wird. Ferner kann die Bitleitung BL auch gleichzeitig mit der Kondensator-Anschlussleitung V_{SS} sowie der zweiten Kondensator-Elektrode CE2 bzw. der Füllschicht für das Kontaktloch ausgebildet werden, wobei vergleichbar zu einem Damaszene-Verfahren beispielsweise in der zweiten Maskenschicht MX20 eine Aussparung auch für die Bitleitung BL an entsprechender Stelle ausgebildet werden muss.

Die Figur 8 zeigt eine vereinfachte Schnittansicht zur Veranschaulichung einer erfindungsgemäßen 1-Transistor-Halbleiterspeicherzelle gemäß einem dritten Ausführungsbeispiel, wobei gleiche Bezugszeichen gleiche oder entsprechende Elemente bezeichnen wie in den Figuren 1 bis 7 und auf eine wiederholte Beschreibung nachfolgend verzichtet wird.

Gemäß Figur 8 kann das Zwischendielektrikum 4 auch eine Mehrschichtenfolge aufweisen, wobei insbesondere eine Schichtenfolge mit einer SiN-Schicht 4A und einer BPSG-Schicht 4B verwendet wird. Die SiN-Schicht 4A dient hierbei als Passivierungsschicht und befindet sich unmittelbar an der Oberfläche des Halbleitersubstrats 1 sowie des strukturierten Gatestapels bestehend aus dem Gate-Dielektrikum 2 und der Steuerelektrode G. Für die Linerschicht 5 bzw. die erste Kondensator-Elektrode CE1 werden wiederum aus üblichen Kontakt-Herstellungsverfahren bekannte Materialien verwendet, wobei insbesondere eine ca. 10 nm dicke TiN-Schicht verwendet wird.

Für das neu im Herstellungsprozess eingeführte Kondensator-Dielektrikum CD bzw. die weitere dielektrische Schicht 7 werden vorzugsweise Siliziumoxid, Siliziumnitrid oder sogenannte high-k-Dielektrika mit hoher relativer Dielektrizitätskonstante verwendet. Die Dicke dieser dielektrischen Schicht 7 weist 3 bis 15 nm auf, wodurch eine Kapazität eingestellt werden kann.

Als Füllschichten 6 und 8 werden für die Kontaktlöcher vorzugsweise die aus herkömmlichen Kontaktverfahren bekannten Wolfram-Stöpsel verwendet, die eine optimale Auffüllung der oftmals sehr tiefen Kontaktlöcher ermöglichen. Für die Bitleitung BL sowie die Kondensator-Anschlussleitung V_{SS} werden, sofern sie nicht einstückig mit den Füllschichten hergestellt werden, vorzugsweise Al-Schichten in einer ersten Metallisierungsebene strukturiert. Es können jedoch in gleicher Weise auch Cu-Schichten oder sonstige hochleitfähige Metallschichten beispielsweise mittels Damaszene-Verfahren in einer ersten oder höheren Metallisierungsebene entsprechend ausgebildet werden.

Figur 9 zeigt eine vereinfachte Draufsicht von 1-T-Halbleiterspeicherzellen gemäß dem ersten bis dritten Ausführungsbeispiel, wobei gleiche Bezugszeichen gleiche oder entsprechende Elemente bezeichnen wie in den Figuren 1 bis 8 und auf eine wiederholte Beschreibung nachfolgend verzichtet wird.

Gemäß Figur 9 weisen die Kontaktlöcher hinsichtlich ihrer Draufsicht eine ovale Form auf. Sie sind jedoch nicht darauf beschränkt und können in gleicher Weise kreisrunde, rechteckige oder sonstige Formen aufweisen. Insbesondere ist hierbei an eine quadratische oder trapezförmige Form zu denken.

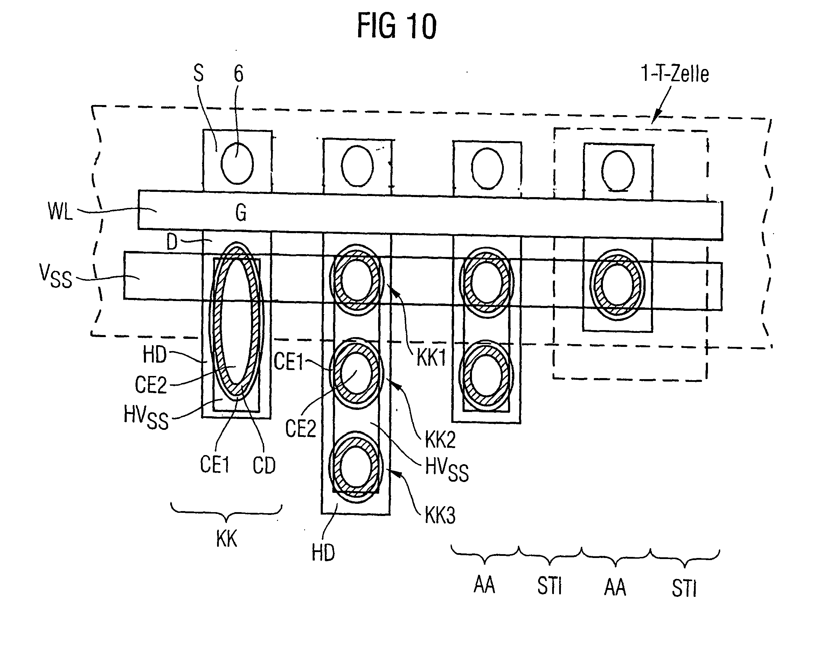

Figur 10 zeigt eine weitere vereinfachte Draufsicht zur Veranschaulichung von erfindungsgemäßen 1-Transistor-Halbleiterspeicherzellen gemäß einem vierten bis sechsten Ausführungsbeispiel, wobei gleiche Bezugszeichen gleiche oder entsprechende Elemente bezeichnen wie in den Figuren 1 bis 9 und auf eine wiederholte Beschreibung nachfolgend verzichtet wird.

Gemäß Figur 10 kann insbesondere das Kontaktloch- zur wahlfreien Einstellung einer Kondensator-Kapazität stark vergrößert sein, wobei ferner im Halbleitersubstrat 1 das Draingebiet D durch ein Hilfs-Draingebiet HD, welches beispielsweise senkrecht zu einer Wortleitung WL angeordnet ist, dieses Dotiergebiet D stark vergrößert. In gleicher Weise kann oberhalb des Zwischendielektrikums 4 ein Hilfs-Anschlussleitungsstück HV_{SS} ausgebildet werden, welches eine ausreichende Kontaktierung der Füllschicht bzw. Füllschichten 8 im bzw. in den Kontaktlöchern ermöglicht. Aufgrund der vergrößerten Elektroden-Flächen ergeben sich vergrößerte Kondensator-Kapazitäten. Auf diese Weise lassen sich beispielsweise Auffrisch-Zyklen wesentlich vergrößern.

Gemäß Figur 10 ist ferner eine 1-Transist-or-Halbleiterspeicherzelle mit zwei oder sogar drei Kontaktloch-Kondensatoren KK1, KK2 und KK3 dargestellt, die wiederum auf einem vergrößerten Hilfs-Draingebiet HD liegen und oberhalb des Zwischendielektrikums 4 wiederum mit einem Hilfs-Anschlussleitungsstück HV_{SS} parallel miteinander verbunden sind.

Durch das ebenfalls im Wesentlichen senkrecht zur Kondensator-Anschlussleitung V_{SS} bzw. zur Wortleitung WL und zur Bitleitung BL senkrecht ausgebildete Hilfs-Anschlussleitungsstück HV_{SS} können demzufolge die drei Kontaktloch-Kondensatoren KK1 bis KK3 mit ihren jeweiligen Kapazitäten parallel geschaltet werden, wodurch sich ihre Gesamtkapazität für die zugehörige 1-Transistor-Halbleiterspeicherzelle entsprechen erhöht. Darüber hinaus besitzt eine derartige modulare Halbleiterspeicherzelle, bei der die Kontaktloch-Kondensatoren in vorbestimmten Kapazitätsgrößen modular aneinandergereiht werden können, den Vorteil, dass eine gewünschte Kapazität auch nachträglich beispielsweise mittels Laser-Trimmens verändert werden kann. Hierbei wären lediglich die nicht erforderlichen Kontaktloch-Kondensatoren durch Trennen bzw. Durchschmelzen der Hilfs-Anschlussleitungsstücke zu entfernen.

Grundsätzlich können jedoch auch unterschiedlich große oder geformte Kontaktloch-Kondensatoren auf die dargestellte Art und Weise verschaltet werden, wodurch eine modulare und feingranulare Anpassung eines Kapazitätswerts an jeweilige Schaltungsanforderungen realisiert werden kann.

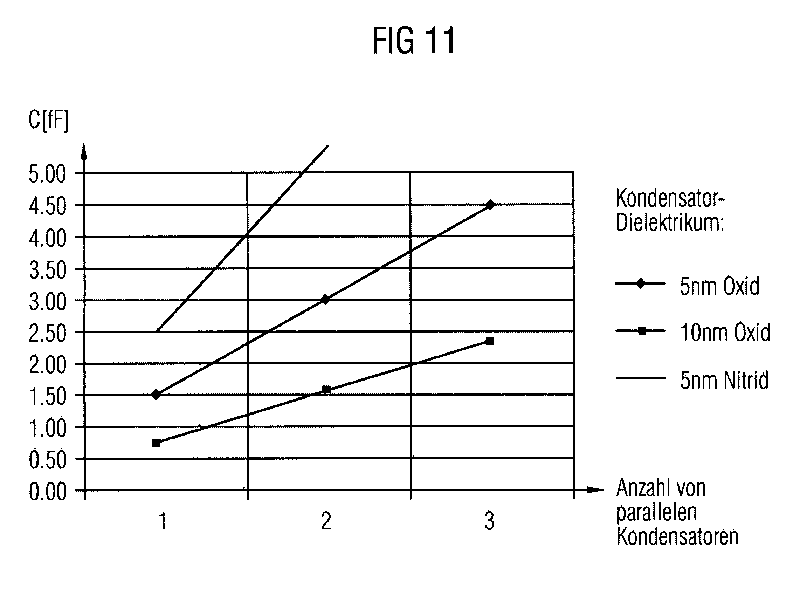

Figur 11 zeigt eine vereinfachte grafische Darstellung zur Veranschaulichung einer Abhängigkeit zwischen einer Gesamtkapazität für einen Kontaktloch-Kondensator in Abhängigkeit vom verwendeten Kondensator-Dielektrikum und der in Figur 10 dargestellten Anzahl von parallel geschalteten Teil-Kondensatoren.

Demzufolge erhält man bereits für einen vergrößerten Kontaktlochkondensator mit ca. 5 nm dicker Nitrid-Schicht als Kondensator-Dielektrikum sehr hohe Kapazitätswerte. Ferner konnte die erwartete Abhängigkeit einer Gesamtkapazität von der Anzahl parallel geschalteter Kondensatoren bestätigt werden.

Die Erfindung wurde vorstehend an Hand einer 1-Transistor-Halbleiterspeicherzelle beschrieben, die in einem Silizium-Halbleitersubstrat ausgebildet ist. Sie ist jedoch nicht darauf beschränkt und umfasst in gleicher Weise die in den Figuren 2 und 3 dargestellten 2-Transistor- und 3-Transistor-Halbleiterspeicherzellen sowie alternative Halbleitermaterialien. Ferner kann der Kontaktloch-Kondensator auch im Kontaktloch für das Sourcegebiet S ausgebildet werden. Obwohl die Kontaktlöcher im Wesentlichen eine ovale Form aufweisen, können in gleicher Weise alternative Kontaktlochformen verwendet werden. Ferner können an Stelle der verwendeten Materialien insbesondere für den Kontaktloch-Kondensator auch alternative Materialien verwendet werden, die eine ausreichend hohe Kondensator-Kapazität ermöglichen.

## Patentansprüche

1. Halbleiterspeicherzelle mit
einem Kontaktloch-Kondensator (KK) zum Speichern von elektrischen Ladungen in zumindest einem Kontaktloch innerhalb eines Zwischendielektrikums (4); und
zumindest einem mit dem Kontaktloch-Kondensator (KK) verbundenen Auswahltransistor (AT) zum Auswählen der Halbleiterspeicherzelle, wobei der Auswahltransistor (AT) ein Sourcegebiet (S) und ein Draingebiet (D) zum Festlegen eines Kanals in einem Halbleitersubstrat (1) aufweist und an der Oberfläche des Kanals ein Gatedielektrikum (2) und darauf eine Steuerelektrode (G) ausgebildet ist,
**dadurch gekennzeichnet, dass**
eine an der Oberfläche des Kontaktlochs ausgebildete erste Kondensator-Elektrode (CE1) nicht bis zur horizontalen Oberfläche des Zwischendielektrikums (4) reicht, und
ein an der Oberfläche der ersten Kondensator-Elektrode (CE1) ausgebildetes Kondensator-Dielektrikum (CD) bis zur horizontalen Oberfläche des Zwischendielektrikums (4) reicht.

2. Halbleiterspeicherzelle nach Patentanspruch 1,
**dadurch gekennzeichnet, dass** das zumindest eine Kontaktloch das Source- oder Draingebiet (S, D) zumindest teilweise freilegt, wobei
die erste Kondensator-Elektrode (CE1) elektrisch leitend mit dem Source- oder Draingebiet (S, D) verbunden ist,
und
an der Oberfläche des Kondensator-Dielektrikums (CD) eine elektrisch leitende Füllschicht (8) zur Realisierung einer zweiten Kondensator-Elektrode (CE2) ausgebildet ist.

3. Halbleiterspeicherzelle nach Patentanspruch 1 oder 2, **dadurch gekennzeichnet, dass** das zumindest eine Kontaktloch hinsichtlich einer Draufsicht eine kreisrunde, ovale oder rechteckige Form aufweist.

4. Halbleiterspeicherzelle nach einem der Patentansprüche 1 bis 3, **dadurch gekennzeichnet, dass** der Kontaktloch-Kondensator (KK) mit einer Kondensator-Anschlussleitung (V_{SS}) verbunden ist, die oberhalb des Zwischendielektrikums (4) ausgebildet ist.

5. Halbleiterspeicherzelle nach Patentanspruch 4, **dadurch gekennzeichnet, dass** die Kondensator-Anschlussleitung ein Hilfs-Anschlussleitungsstück (HV_{SS}) aufweist, das im Wesentlichen senkrecht zur Kondensator-Anschlussleitung (V_{SS}) auf dem Zwischendielektrikum (4) ausgebildet ist.

6. Halbleiterspeicherzelle nach Patentanspruch 5, **dadurch gekennzeichnet, dass** eine Vielzahl von Kontaktloch-Kondensatoren (KK1 bis KK3) für ein jeweiliges Source- oder Draingebiet (S, D) eines Auswertetransistors (AT) ausgebildet ist, wobei das zumindest eine Hilfs-Anschlussleitungsstück (HV_{SS}) die Vielzahl von Kontaktloch-Kondensatoren (KK1 bis KK3) parallel miteinander verbindet.

7. Halbleiterspeicherzelle nach einem der Patentansprüche 1 bis 6, **dadurch gekennzeichnet, dass** das Kondensator-Dielektrikum (CD) ein Oxid, Nitrid und/oder high-k-Material aufweist.

8. Halbleiterspeicherzelle nach einem der Patentansprüche 1 bis 7, **dadurch gekennzeichnet, dass** die erste Kondensator-Elektrode (CE1) als Linerschicht (5) auch an der Oberfläche von zumindest einem weiteren Kontaktloch für das jeweils verbleibende Source- oder Draingebiet (S, D) ausgebildet ist und die elektrisch leitende Füllschicht (8) ferner dieses Kontaktloch auffüllt.

9. Halbleiterspeicherzelle nach einem der Patentansprüche 1 bis 8, **dadurch gekennzeichnet, dass** sie eine 1-Transistor-, 2-Transistor- oder 3-Transistor-Speicherzelle darstellt.

10. Verfahren zur Herstellung einer Halbleiterspeicherzelle mit einem Kontaktloch-Kondensator (KK) und zumindest einem damit verbundenen Auswahltransistor (AT) mit den Schritten:
a) Vorbereiten eines Halbleitersubstrats (1);
b) Ausbilden des Auswahltransistors (AT) mit einem Sourcegebiet (S) und einem Draingebiet (D) zum Festlegen eines Kanals im Halbleitersubstrat, wobei an der Oberfläche des Kanals ein Gatestapel mit einem Gatedielektrikum (2) und einer Steuerelektrode (G) ausgebildet ist;
c) Ausbilden eines Zwischendielektrikums (4) an der Oberfläche des Halbleitersubstrats (1) und des Gatestapels (2, G);
d) Ausbilden von Kontaktlöchern für den Kontaktloch-Kondensator (KK) und das verbleibende Source- oder Draingebiet im Zwischendielektrikum (4) zum zumindest teilweisen Freilegen des Sourcegebiets (S) und des Draingebiets (D) des Auswahltransistors (AT);
e) Ausbilden einer Linerschicht (5) als erste Kondensator-Elektrode (CE1) an der Oberfläche des Halbleitersubstrats (1) und des zumindest einen Kontaktlochs für den Kontaktloch-Kondensator (KK), wobei die erste Kondensator-Elektrode (CE1) nicht bis zur horizontalen Oberfläche des Zwischendielektrikums (4) heranreicht;
f) Ausbilden einer weiteren dielektrischen Schicht (7) als Kondensatordielektrikum (CD) an der Oberfläche der erste Kondensatorelektrode (CE1), welche bis zur horizontalen Oberfläche des Zwischendielektrikums (4) reicht;
g) Ausbilden einer elektrisch leitenden Füllschicht (8) als zweite Kondensator-Elektrode (CE2) an der Oberfläche des Kondensator-Dielektrikums (CD) innerhalb des zumindest einen Kontaktlochs für den Kontaktloch-Kondensator (KK); und
h) Ausbilden einer Kondensator-Anschlussleitung (V_{SS}) an der Oberfläche des Zwischendielektrikums (4) und der Füllschicht (8) zum Anschließen der zweiten Kondensator-Elektrode (CE2).

11. Verfahren nach Patentanspruch 10, **dadurch gekennzeichnet, dass** in Schritt a) Isolationsgräben (STI) zum Festlegen von aktiven Gebieten (AA) im Halbleitersubstrat (1) ausgebildet werden.

12. Verfahren nach Patentanspruch 10 oder 11, **dadurch gekennzeichnet, dass** in Schritt b) eine Gate-Isolationsschicht (2) ganzflächig an der Oberfläche des Halbleitersubstrats (1) und eine Steuerelektrodenschicht (3) ganzflächig an der Oberfläche der Gate-Isolationsschicht (2) ausgebildet und zur Realisierung von Gatestapeln strukturiert wird, wobei mittels Ionenimplantation die Source- und Draingebiete (S, D) des Auswahltransistors (AT) selbstjustierend ausgebildet werden.

13. Verfahren nach einem der Patentansprüche 10 bis 12, **dadurch gekennzeichnet, dass** in Schritt c) als Zwischendielektrikum (4) eine Mehrschichtenfolge mit einer SiN-Schicht (4A) und einer BPSG-Schicht (4B) ausgebildet wird.

14. Verfahren nach einem der Patentansprüche 10 bis 13, **dadurch gekennzeichnet, dass** in Schritt d) Kontaktlöcher für den Kontaktloch-Kondensator (KK) sowie für das verbleibende Source- oder Draingebiet (S, D) gleichzeitig ausgebildet werden.

15. Verfahren nach einem der Patentansprüche 10 bis 14, **dadurch gekennzeichnet, dass** in Schritt d) eine Vielzahl von Kontaktlöchern für eine Vielzahl von Kontaktloch-Kondensatoren (KK1 bis KK3) ausgebildet werden.

16. Verfahren nach einem der Patentansprüche 10 bis 15, **dadurch gekennzeichnet, dass** die Kontaktlöcher hinsichtlich einer Draufsicht kreisrund, oval und/oder rechteckig ausgebildet werden.

17. Verfahren nach einem der Patentansprüche 10 bis 16, **dadurch gekennzeichnet, dass** in Schritt e) die Linerschicht (5) gleichzeitig auch im Kontaktloch für das verbleibende Source-oder Draingebiet (S, D) ausgebildet wird.

18. Verfahren nach einem der Patentansprüche 10 bis 17, **dadurch gekennzeichnet, dass** in Schritt e) die Linerschicht (5) ganzflächig ausgebildet und anschließend zum Freilegen eines oberen Kontaktlochbereichs zurückgeätzt wird.

19. Verfahren nach einem der Patentansprüche 10 bis 18, **dadurch gekennzeichnet, dass** in Schritt e) eine ca. 10 nm dicke TiN-Schicht abgeschieden wird.

20. Verfahren nach einem der Patentansprüche 10 bis 19, **dadurch gekennzeichnet, dass** in Schritt f) das Kontaktloch für das verbleibende Source- oder Draingebiet (S, D) mit einer ersten Maske (MX1) aufgefüllt wird, die weitere dielektrische Schicht (7) ganzflächig abgeschieden wird, anschließend bis zur Oberfläche des Zwischendielektrikums (4) planarisiert wird und die erste Maske (MX10) aus dem Kontaktloch für das verbleibende Source- oder Draingebiet (S, D) entfernt wird.

21. Verfahren nach einem der Patentansprüche 10 bis 19, **dadurch gekennzeichnet, dass** in Schritt f) das Kontaktloch für den Kontaktloch-Kondensator (KK) mit einer ersten Maske (MX10) aufgefüllt wird, das Kontaktloch für das verbleibende Source- oder Draingebiet (S, D) mit einer zweiten elektrisch leitenden Füllschicht (6) aufgefüllt wird, die erste Maske (MX10) entfernt wird, eine zweite Maske (MX20) ausgebildet wird, die nur das Kontaktloch für den Kontaktloch-Kondensator (KK) freilässt, und die weitere dielektrische Schicht (7) ganzflächig abgeschieden wird.

22. Verfahren nach einem der Patentansprüche 10 bis 21, **dadurch gekennzeichnet, dass** in Schritt g) die elektrisch leitende Füllschicht (8) ganzflächig abgeschieden und bis zur Oberfläche des Zwischendielektrikums (4) planarisiert wird.

23. Verfahren nach einem der Patentansprüche 10 bis 21, **dadurch gekennzeichnet, dass** die Schritte g) und h) gleichzeitig durchgeführt werden, wobei die elektrisch leitende Füllschicht (8) ganzflächig abgeschieden und anschließend zum Ausbilden der Kondensator-Anschlussleitung (V_{SS}) strukturiert wird.

24. Verfahren nach einem der Patentansprüche 15 bis 23, **dadurch gekennzeichnet, dass** in Schritt h) ferner ein Hilfs-Anschlussleitungsstück (HV_{SS}) für eine Vielzahl von Kontaktloch-Kondensatoren (KK1 bis KK3) ausgebildet wird.

25. Verfahren nach einem der Patentansprüche 10 bis 24, **dadurch gekennzeichnet, dass** in Schritt h) ferner gleichzeitig eine Bitleitung (BL) für das verbleibende Source- oder Draingebiet (S, D) ausgebildet wird.

## Claims

1. Semiconductor memory cell having
a contact hole capacitor (KK) for storing electrical charges in at least one contact hole within an inter-dielectric (4); and
at least one selection transistor (AT) connected to the contact hole capacitor (KK) for selecting the semiconductor memory cell, the selection transistor (AT) comprising a source region (S) and a drain region (D) for establishing a channel in a semiconductor substrate (1), a gate dielectric (2) being formed on the surface of the channel and a control electrode (G) being formed thereon,
**characterized in that**
a first capacitor electrode (CE1) formed on the surface of the contact hole does not reach to the horizontal surface of the inter-dielectric (4), and
a capacitor dielectric (CD) formed on the surface of the first capacitor electrode (CE1) reaches to the horizontal surface of the inter-dielectric (4).

2. Semiconductor memory cell according to Patent Claim 1, **characterized in that** the at least one contact hole at least partially exposes the source or drain region (S, D),
the first capacitor electrode (CE1) being electrically conductively connected to the source or drain region (S, D), and
an electrically conductive filler layer (8) for producing a second capacitor electrode (CE2) is formed on the surface of the capacitor dielectric (CD).

3. Semiconductor memory cell according to Patent Claim 1 or 2, **characterized in that** the at least one contact hole has a circularly round, oval or rectangular shape in respect of plan view.

4. Semiconductor memory cell according to one of Patent Claims 1 to 3, **characterized in that** the contact hole capacitor (KK) is connected to a capacitor connection line (V_{SS}) which is arranged above the inter-dielectric (4).

5. Semiconductor memory cell according to Patent Claim 4, **characterized in that** the capacitor connection line comprises an auxiliary connection line section (HV_{SS}) which is formed on the inter-dielectric (4), essentially perpendicularly to the capacitor connection line (V_{SS}).

6. Semiconductor memory cell according to Patent Claim 5, **characterized in that** a multiplicity of contact hole capacitors (KK1 to KK3) are formed for a respective source or drain region (S, D) of a selection transistor (AT), the at least one auxiliary connection line section (HV_{SS}) connecting the multiplicity of contact hole capacitors (KK1 to KK3) together in parallel.

7. Semiconductor memory cell according to one of Patent Claims 1 to 6, **characterized in that** the capacitor dielectric (CD) comprises an oxide, nitride and/or high-k material

8. Semiconductor memory cell according to one of Patent Claims 1 to 7, **characterized in that** the first capacitor electrode (CE1) is also formed as a liner layer (5) on the surface of at least one further contact hole for the respectively remaining source or drain region (S, D) and the electrically conductive filler layer (8) furthermore fills up this contact hole.

9. Semiconductor memory cell according to one of Patent Claims 1 to 8, **characterized in that** is constitutes a 1-transistor, 2-transistor, 3-transistor, memory cell.

10. Method for the production of a semiconductor memory cell having a contact hole capacitor (KK) and at least one selection transistor (AT) connected thereto, having the steps of:
a) preparing a semiconductor substrate (1);
b) forming the selection transistor (AT) with a source region (S) and a drain region (D) for establishing a channel in the semiconductor substrate, a gate stack having a gate dielectric (2) and a control electrode (G) being formed on the surface of the channel;
c) forming an inter-dielectric (4) on the surface of the semiconductor substrate (1) and of the gate stack (2, G);
d) forming contact holes for the contact hole capacitor (KK) and the remaining source or drain region in the inter-dielectric (4) to at least partially expose the source region (S) and the drain region (D) of the selection transistor (AT);
e) forming a liner layer (5) as a first capacitor electrode (CE1) on the surface of the semiconductor substrate (1) and of the at least one contact hole for the contact hole capacitor (KK), the first capacitor electrode (CE1) not reaching to the horizontal surface of the inter-dielectric (4);
f) forming a further dielectric layer (7), which reaches to the horizontal surface of the inter-dielectric (4), as a capacitor dielectric (CD) on the surface of the first capacitor electrode (CE1);
g) forming an electrically conductive filler layer (8) as a second capacitor electrode (CE2) on the surface of the capacitor dielectric (CD) inside the at least one contact hole for the contact hole capacitor (KK); and
h) forming a capacitor connection line (V_{SS}) on the surface of the inter-dielectric (4) and of the filler layer (8) to connect the second capacitor electrode (CE).

11. Method according to Patent Claim 10, **characterized in that** in step a) isolation trenches (STI) for establishing active areas (AA) are formed in the semiconductor substrate (1).

12. Method according to Patent Claim 10 or 11, **characterized in that** in step b) a gate insulation layer (2) is formed surface-wide on the surface of the semiconductor substrate (1), and a control electrode layer (3) is formed surface-wide on the surface of the gate insulation layer (2) and structured to produce gate stacks, the source and drain regions (S, D) of the selection transistor (AT) being formed in a self-aligning fashion by means of ion implantation.

13. Method according to one of Patent Claims 10 to 12, **characterized in that** in step c) a multilayer sequence having an SiN layer (4A) and a BPSG layer (4B) are formed.

14. Method according to one of Patent Claims 10 to 13, **characterized in that** in step d) contact holes for the contact hole capacitor (KK) and for the remaining source or drain region (S, D) are simultaneously formed.

15. Method according to one of Patent Claims 10 to 14, **characterized in that** in step d) a multiplicity of contact holes for a multiplicity of contact hole capacitors (KK1 to KK3) are formed.

16. Method according to one of Patent Claims 10 to 15, **characterized in that** the contact holes are formed to be circularly round, ovally or rectangularly in respect of plan view.

17. Method according to one of Patent Claims 10 to 16, **characterized in that** in step e) the liner layer (5) is also formed simultaneously in the contact hole for the remaining source or drain region (S, D).

18. Method according to one of Patent Claims 10 to 17, **characterized in that** in step e) the liner layer (5) is formed surface-wide and subsequently etched back to expose an upper contact hole zone.

19. Method according to one of Patent Claims 10 to 18, **characterized in that** in step e) an approximately 10 nm thick TiN layer is deposited.

20. Method according to one of Patent Claims 10 to 19, **characterized in that** in step f) the contact hole for the remaining source or drain region (S, D) is filled with a first mask (MX1), the further dielectric layer (7) is deposited surface-wide, subsequently planarized to the surface of the inter-dielectric (4) and the first mask (MX10) is removed from the contact hole for the remaining source or drain region (S, D).

21. Method according to one of Patent Claims 10 to 19, **characterized in that** in step f) the contact hole for the contact hole capacitor (KK) is filled with a first mask (MX10), the contact hole for the remaining source or drain region (S, D) is filled with a second electrically conductive filler layer (6), the first mask (MX10) is removed, a second mask (MX20) which exposes only the contact hole for the contact hole capacitor (KK) is formed, and the further dielectric layer (7) is deposited surface-wide.

22. Method according to one of Patent Claims 10 to 21, **characterized in that** in step g) the electrically conductive filler layer (8) is deposited surface-wide and planarized to the surface of the inter-dielectric (4).

23. Method according to one of Patent Claims 10 to 21, **characterized in that** steps g) and h) are carried out simultaneously, the electrically conductive filler layer (8) being deposited surface-wide and subsequently structured to form the capacitor connection line (V_{SS}).

24. Method according to one of Patent Claims 15 to 23, **characterized in that** in step h) an auxiliary connection line section (HV_{SS}) is furthermore formed for a multiplicity of contact hole capacitors (KK1 to KK3).

25. Method according to one of Patent Claims 10 to 24, **characterized in that** in step h) a bit line (BL) for the remaining source or drain region (S, D) is furthermore formed simultaneously.

## Revendications

1. Cellule de mémoire à semiconducteur, comprenant un condensateur (KK) à trou de contact pour mémoriser des charges électriques dans au moins un trou de contact au sein d'un diélectrique (4) intermédiaire ; et
au moins un transistor (AT) de sélection, qui est relié au condensateur (KK) à trou de contact et qui est destiné à sélectionner la cellule de mémoire à semiconducteur, le transistor (AT) de sélection ayant une zone (S) de source et une zone (D) de drain pour la fixation d'un canal dans un substrat (1) semiconducteur et à la surface du canal est formé un diélectrique (2) de grille et dessus une électrode (G) de commande,
**caractérisée en ce que**
une première électrode (CE1) de condensateur formée à la surface du trou de contact ne va pas jusqu'à la surface horizontale du diélectrique (4) intermédiaire, et
un diélectrique (CD) de condensateur formé à la surface de la première électrode (CE1) de condensateur va jusqu'à la surface horizontale du diélectrique (4) intermédiaire.

2. Cellule de mémoire à semiconducteur suivant la revendication 1,
**caractérisée en ce que** le au moins un trou de contact dégage, au moins en partie, la zone (S, D) de source ou de drain, dans laquelle
la première électrode (CE1) de condensateur est reliée d'une manière conductrice de l'électricité à la zone (S, D) de source ou de drain, et
à la surface du diélectrique (CD) de condensateur est formée une couche (8) de remplissage conductrice de l'électricité pour la réalisation d'une deuxième électrode (CE2) de condensateur.

3. Cellule de mémoire à semiconducteur suivant la revendication 1 ou 2, **caractérisée en ce que** le au moins un trou de contact a en vue en plan une forme circulaire, ovale ou rectangulaire.

4. Cellule de mémoire à semiconducteur suivant l'une des revendications 1 à 3, **caractérisée en ce que** le condensateur (KK) à trou de contact est relié à une ligne (V_{SS}) de connexion de condensateur, qui est formée au-dessus du diélectrique (4) intermédiaire.

5. Cellule de mémoire à semiconducteur suivant la revendication 4, **caractérisée en ce que** la ligne de connexion de condensateur comporte une pièce (HV_{SS}) de ligne de connexion auxiliaire, qui est formée sur le diélectrique (4) intermédiaire sensiblement perpendiculairement à la ligne (V_{SS}) de connexion de condensateur.

6. Cellule de mémoire à semiconducteur suivant la revendication 5, **caractérisée en ce qu'**une pluralité de condensateurs (KK1 à KK3) à trou de contact est formée pour une zone (S, D) respective de source ou de drain d'un transistor (AT) d'exploitation, la au moins une pièce (HV_{SS}) de ligne de connexion auxiliaire reliant entre eux en parallèle la pluralité de condensateurs (KK1 à KK3) à trou de contact.

7. Cellule de mémoire à semiconducteur suivant l'une des revendications 1 à 6, **caractérisée en ce que** le diélectrique (CD) de condensateur comporte un oxyde, un nitrure et/ou un matériau à grand k.

8. Cellule de mémoire à semiconducteur suivant l'une des revendications 1 à 7, **caractérisée en ce que** la première électrode (CE1) de condensateur est sous la forme d'une couche (5) de liner également à la surface d'au moins un autre trou de contact pour la zone (S, D) de source ou de drain restante respectivement et la couche (8) de remplissage de l'électricité remplit, en outre, ce trou de contact.

9. Cellule de mémoire à semiconducteur suivant l'une des revendications 1 à 8, **caractérisée en ce qu'**elle constitue une cellule de mémoire à 1 transistor, à 2 transistors ou à 3 transistors.

10. Procédé de fabrication d'une celle de mémoire à semiconducteur ayant un condensateur (KK) à trou de contact et au moins un transistor (AT) de sélection, qui y est relié, comprenant les stades :
a) on prépare un substrat (1) semiconducteur ;
b) on forme le transistor (AT) de sélection avec une zone (S) de source et une zone (D) de drain pour la fixation d'un canal dans le substrat semiconducteur, un empilement de grille ayant un diélectrique (2) de grille et une électrode (G) de commande étant formé à la surface du canal ;
c) on forme un diélectrique (4) intermédiaire à la surface du substrat (1) semiconducteur et de l'empilement (2, G) de grille ;
d) on forme des trous de contact pour le condensateur (KK) à trou de contact et la zone restante de source ou de drain dans le diélectrique (4) intermédiaire pour mettre à nu, au moins en partie, la zone (S) de source et la zone (D) de drain du transistor (AT) de sélection ;
e) on forme une couche (5) de liner comme première électrode (CE1) de condensateur à la surface du substrat (1) semiconducteur et du au moins un trou de contact pour le condensateur (KK) à trou de contact, la première électrode (CE1) de condensateur n'allant pas jusqu'à la surface horizontale du diélectrique (4) intermédiaire ;
f) on forme une autre couche (7) diélectrique comme diélectrique (CD) de condensateur à la surface de la première électrode (CE1) de condensateur, cette couche (7) allant jusqu'à la surface horizontale du diélectrique (4) intermédiaire ;
g) on forme une couche (8) de remplissage conductrice de l'électricité comme deuxième électrode (CE2) de condensateur à la surface du diélectrique (CD) de condensateur à l'intérieur du au moins un trou de contact pour le condensateur (KK) à trou de contact ; et
h) on forme une ligne (V_{SS}) de connexion de condensateur à la surface du diélectrique (4) intermédiaire et de la couche (8) de remplissage pour la connexion de la deuxième électrode (CE2) de condensateur.

11. Procédé suivant la revendication 10, **caractérisé en ce qu'**au stade a) on forme des sillons (STI) isolants pour la fixation de zone (AA) active dans le substrat (1) semiconducteur.

12. Procédé suivant la revendication 10 ou 11, **caractérisé en ce qu'**au stade b) on forme une couche (2) isolante de grille sur toute la surface à la surface du substrat (1) semiconducteur et une couche (3) d'électrode de commande sur toute la surface à la surface de la couche (2) isolante de grille et on la structure pour la réalisation d'empilements de grille, les zones (S, D) de source et de drain du transistor (AT) de sélection étant formées avec auto-alignement au moyen d'une implantation d'ions.

13. Procédé suivant l'une des revendications 10 à 12, **caractérisé en ce qu'**au stade c) on forme comme diélectrique (4) intermédiaire une succession à plusieurs couches ayant une couche (4A) en SiN et une couche (4B) en BPSG.

14. Procédé suivant l'une des revendications 10 à 13, **caractérisé en ce qu'**au stade d) on forme en même temps des trous de contact pour le condensateur (KK) à trou de contact ainsi que pour la zone (S, D) de source ou de drain restante.

15. Procédé suivant l'une des revendications 10 à 14, **caractérisé en ce qu'**au stade d) on forme une pluralité de trous de contact pour une pluralité de condensateurs (KK1 à KK3) à trou de contact.

16. Procédé suivant l'une des revendications 10 à 15, **caractérisé en ce qu'**on donne aux trous de contact en vue en plan une forme circulaire, ovale et/ou rectangulaire.

17. Procédé suivant l'une des revendications 10 à 16, **caractérisé en ce qu'**au stade e) on forme la couche (5) de liner en même temps dans le trou de contact pour la zone (S, D) restante de source ou de drain.

18. Procédé suivant l'une des revendications 10 à 17, **caractérisé en ce qu'**au stade e) on forme sur toute la surface la couche (5) de liner et ensuite on l'attaque en retrait pour mettre à nu une partie supérieure de trou de contact.

19. Procédé suivant l'une des revendications 10 à 18, **caractérisé en ce qu'**au stade e) on dépose une couche de TiN en une épaisseur d'environ 10 nm.

20. Procédé suivant l'une des revendications 10 à 19, **caractérisé en ce qu'**au stade f) on remplit d'un premier masque (MX1) le trou de contact pour la zone (S, D) restante de source ou de drain, on dépose sur toute la surface l'autre couche (7) diélectrique, ensuite on planarise jusqu'à la surface du diélectrique (4) intermédiaire et on élimine le premier masque (MX10) du trou de contact pour la zone (S, D) restante de source ou de drain.

21. Procédé suivant l'une des revendications 10 à 19, **caractérisé en ce qu'**au stade f) on remplit d'un premier masque (MX10) le trou de contact pour le condensateur (KK) à trou de contact, on remplit d'une deuxième couche (6) de remplissage conductrice d'électricité le trou de contact pour la zone (S, D) restante de source ou de drain, on élimine le masque (MX10), on forme un deuxième masque (MX20), qui ne laisse libre que le trou de contact pour le condensateur (KK) à trou de contact, et on dépose sur toute la surface l'autre couche (7) diélectrique.

22. Procédé suivant l'une des revendications 10 à 21, **caractérisé en ce qu'**au stade g) on dépose sur toute la surface la couche (8) de remplissage conductrice d'électricité et on la planarise jusqu'à la surface du diélectrique (4) intermédiaire.

23. Procédé suivant l'une des revendications 10 à 21, **caractérisé en ce qu'**on effectue en même temps les stades g) et h), la couche (8) de remplissage conductrice d'électricité étant déposée sur toute la surface et étant ensuite structurée pour former la ligne (V_{SS}) de connexion de condensateur.

24. Procédé suivant l'une des revendications 15 à 23, **caractérisé en ce qu'**au stade h) on forme, en outre, une pièce (HV_{SS}) de ligne de connexion auxiliaire pour une pluralité de condensateurs (KK1 à KK3) à trou de contact.

25. Procédé suivant l'une des revendications 10 à 24, **caractérisé en ce qu'**au stade h) on forme, en outre, simultanément une ligne (BL) de bit pour la zone (S, D) restante de source ou de drain.
